# EUROPEAN PATENT APPLICATION

(11) **EP 4 586 747 A2**
(43) Date of publication of application: **16.07.2025**
(21) Application number: 25150524.4
(22) Date of filing: 07.01.2025
(51) Int. Cl.: H05K 1/02, H05K 1/11, H05K 3/34, H05K 3/28, H05K 3/30

(54) **COVERLAY AS PRINTED CIRCUIT BOARD (PCB) VOLTAGE INSULATOR UNDER CONNECTORS**

(30) Priority: 09.01.2024 US 202418407625
(71) Applicant: Hamilton Sundstrand Corporation, Charlotte, NC 28217-4578 (US)
(72) Inventor: COONEY, Robert C., Janesville 53546 (US); BAUER, John A., Marion 52302-9056 (US)
(74) Representative: Dehns

(57) **Abstract**

A circuit board system includes a printed circuit board (PCB (102)) having a first side (104) and a second side (106) opposite the first side (104). A plurality of plated through holes (PTHs (108)) are defined through the PCB (102) from the first side (104) to the second side (106). A respective pad (110) is defined at each end of each PTH of the plurality of PTHs (108). The PCB (102) includes circuit traces electrically interconnecting among the plurality of PTHs (108) for forming PCB circuitry. A coverlay (114) is adhered to the first side (104) of the PCB (102) for insulating voltages among the plurality of PTHs (108).

## Description

### BACKGROUND

### 1. Field

The present disclosure relates to circuit boards, and more particularly to voltage insulation for circuit boards.

### 2. Description of Related Art

On printed circuits boards (PCBs), connectors for low current signals have relatively close spacing between conductors. High voltage signals require large spacing between conductors. Electrical spacing is from pad to pad for plated through holes (PTHs) where the connectors are seated, and this spacing is significantly less than the pin-to-pin spacing. There are very limited options for electrically insulating between the plated through hole pads on compliant pin pressed connectors. Applying a vapor deposition conformal coating, for example, Parylene, requires extensive masking to prevent the coating from depositing on the mating surfaces of the contacts. Applying a conformal coating to the PCB, coating the pads and plated through holes, and subsequently pressing the connector through the coating results in a low reliability electrical connection because the compliant contact typically does not pierce the coating to the full depth. The pierced conformal coating can, if dislodged from the plated through hole, become foreign object debris (FOD) and could migrate around the electronics product. In addition non-conductive coating could come in contact between the connector lead and the plated barrel creating interconnect reliability issues.

The conventional techniques have been considered satisfactory for their intended purpose. However, there is an ever-present need for improved systems and methods for insulating ever-increasing voltages in PCBs. This disclosure provides a solution for this need.

### SUMMARY

A circuit board system includes a printed circuit board (PCB) having a first side and a second side opposite the first side. A plurality of plated through holes (PTHs) are defined through the PCB from the first side to the second side. A respective pad is defined at each end of each PTH of the plurality of PTHs. The PCB includes circuit traces electrically interconnecting among the plurality of PTHs forming PCB circuitry. A coverlay is adhered to the first side of the PCB for insulating voltages among the plurality of PTHs.

A plurality of pin contacts can be included. Each pin contact of the plurality of pin contacts can extend through the coverlay and a respective one of the PTHs of the plurality of PTHs. The coverlay can include an overhang in each of the plurality of PTHs wherein the coverlay extends radially inward toward the respective pin contact beyond the respective pad. The coverlay can be a first coverlay and a second coverlay can be adhered to the second side of the PCB. The second coverlay can include an overhang in each of the plurality of PTHs wherein the coverlay extends radially inward toward the respective pin contact beyond the respective pad.

The plurality of pin contacts can be compliant, seated within the respective lining of each PTH of the plurality of PTHs with an interference fit. The plurality of pin contacts can be secured within the respective lining of each PTH of the plurality of PTHs with a solder joint. An opening through the second coverlay for each pad can be bigger than a corresponding opening through the first coverlay. The pads lining each PTH of the plurality of PTHs can be spaced apart from one another by as few as 17 thousandths of an inch (0.4322 mm).

A method of making a circuit board system includes adhering a coverlay onto a first side of a printed circuit board (PCB) having a second side opposite the first side, wherein a plurality of plated through holes (PTHs) are defined through the PCB from the first side to the second side, wherein a respective pad is defined at each end of each PTH of the plurality of PTHs, and wherein the PCB includes circuit traces interconnecting among the plurality of PTHs. The method includes placing a plurality of pin contacts through the coverlay, each pin contact of the plurality of pin contacts extending through the coverlay and a respective one of the PTHs of the plurality of PTHs with the coverlay insulating voltages among the plurality of PTHs.

The method can include adhering a second coverlay onto the second side of the PCB. The method can include placing a plurality of pin contacts in the plurality if PTHs, respectively, after adhering the first and second coverlays onto the first and second side of the PCB. Placing the plurality of pin contacts can include piercing the coverlay with the plurality of pin contacts after adhering the coverlay onto the first side of the PCB.

The method can include forming a plurality of holes for the plurality of pin contacts through the coverlay prior to adhering the coverlay to the first side of the PCB so the plurality of pin contacts can be placed through the coverlay without piercing the coverlay. The method can include soldering the plurality of pin contacts to the respective pads. Each hole in the first plurality of holes can have a first diameter. The method can include forming a second plurality of holes for the plurality of pin contacts through the second coverlay prior to adhering the second coverlay to the second side of the PCB so the plurality of pin contacts can be placed through the second coverlay without piercing the second coverlay. Each hole in the second plurality of holes can have a second diameter larger than the first diameter so solder can be applied through the plurality of second holes to connect the plurality of pin contacts to the plurality of pads without thermally compromising the second coverlay.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:
Fig. 1 is a schematic cross-sectional side elevation view of an embodiment of a printed circuit board (PCB) system constructed in accordance with the present disclosure, showing the coverlays on the top and bottom sides of the PCB as oriented in Fig. 1; and
Fig. 2 is a schematic cross-sectional side elevation view of the PCB system of Fig. 1, showing holes formed in the coverlays prior to adhering the coverlays to the PCB.

### DETAILED DESCRIPTION OF THE PREFERRED EMBODIMENTS

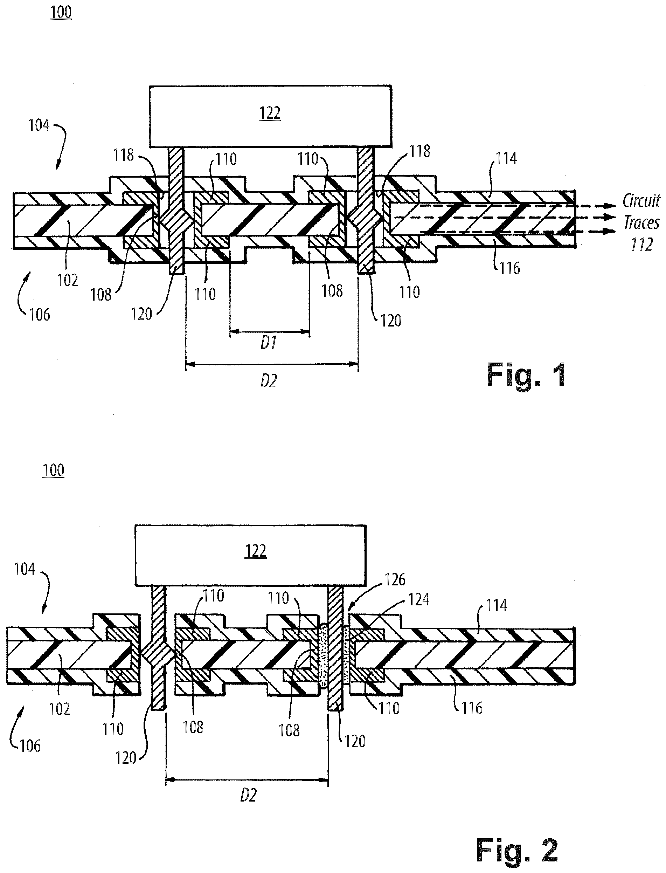

Reference will now be made to the drawings wherein like reference numerals identify similar structural features or aspects of the subject disclosure. For purposes of explanation and illustration, and not limitation, a partial view of an embodiment of a printed circuit board (PCB) system in accordance with the disclosure is shown in Fig. 1 and is designated generally by reference character 100. Other embodiments of systems in accordance with the disclosure, or aspects thereof, are provided in Fig. 2, as will be described. The systems and methods described herein can be used to provide electrical insulation on PCB systems with tight spacing between contact pins and plated through hole (PTH) pads.

The circuit board system 100 includes a printed circuit board (PCB) 102 having a first side 104 and a second side 106 opposite the first side. A plurality of plated through holes (PTHs) 108 are defined through the PCB 102 from the first side 104 to the second side 106. A respective pad 110 is defined at each end of each PTH 108. The surface pads lining each PTH of the plurality of PTHs are spaced apart from one another by as few as 30 thousandths of an inch (0.762 mm), as few as 17 thousandths of an inch (0.4318 mm), or even less. This pad to pad spacing D1 is smaller than the pin to pin spacing D2.

The PCB 102 includes circuit traces 112 electrically interconnecting among the plurality of PTHs 108, and the circuit traces can be formed on the first side 104, on the second side 106, and/or embedded in the PCB 102 between the first and second sides 104, 106 as indicated by the broken lines in Fig. 1, for forming PCB circuitry together with components 122, which are further described below. A polyimide film, or other suitable polymer, coverlay 114 is adhered with an acrylic, or other suitable material, adhesive to the first side 106 of the PCB 102 for insulating voltages among the plurality of PTHs 108. A second coverlay 116 may be adhered to the second side 106 of the PCB 102.

The coverlay 114 includes an overhang 118 in each of the plurality of PTHs 108 wherein the coverlay 114 extends radially inward toward the respective pin contact 120 beyond the respective pad 110. The second coverlay 116 similarly includes an overhang 118 in each of the plurality of PTHs 108 wherein the coverlay 116 extends radially inward toward the respective pin contact 120 beyond the respective pad 110. A plurality of pin contacts 120 are included, only two of which are shown in Fig. 1, for connecting electrical components 122 such as connectors, resistors, transistors, capacitors, inductors, and the like, to the circuit traces 112 for functional circuitry. Each pin contact 120 extends through the coverlays 114, 116 and a respective one of the PTHs 108. In Fig. 1, the pin contacts 120 are compliant, seated within the respective lining of each PTH 108 with an interference fit for mechanical and electrical connection. It is also contemplated that the pin contacts can be secured within the respective lining of each PTH 108 with a solder joint 124, not shown in Fig. 1 but see Fig. 2. As also shown in Fig. 2, an opening 126 through the coverlay 114, 116 for each pad can be pre-formed into the coverlays 114, 116 prior to adhering the coverlays 114, 116 to the PCB 102 so the plurality of pin contacts 120 can be placed through the coverlays 114, 116 without needing to pierce the coverlay 114, 116.

The openings 126 can be smaller than the corresponding openings through the PTHs 108 to ensure the overhangs 118 shown in Fig. 1. It is also contemplated that the openings 126 can be the same size as the openings through the PTHs 108. If solder is used, the openings 126 can be larger than the openings through the PTHs 108, for example, the openings 126 in the bottom coverlay 116 as oriented in Fig. 2 can be larger than the corresponding openings through the PTHs 108 to facilitate soldering the pins 120 to the linings of the PTHs 108 after adhering the coverlays 114, 116 to the PCB 102, without thermally compromising the coverlay 116. If compliant pins 120 are used, the system 100 can be created by piercing the coverlays 114, 116 with the contact pins 120 while seating the contact pins in the PTHs 108 after adhering the coverlays 114, 116 to the PCB 102. After assembly with soldering or interference fits, the coverlays 114, 116 insulate voltages among the plurality of PTHs 108.

The coverlays 114, 116 can each be layer of flexible adhesive coated polyimide film with acrylic adhesive layer laminated to the surface of a PCB 102. The film can typically be 0.001 inch (0.0254 mm) thick dielectric cover layer per IPC-4203/11, or other similar material. The film covers the pad 110 portion of the PTHs 108. The film can optionally completely cover the hole of the PTH 108. The film can optionally have a hole that is in the middle of the PTH 108 to easily allow a compliant pin 120 to pierce the film. If there is a hole in the film, the amount of acrylic adhesive that could end up in the PTH 108 is reduced.

Systems and methods as disclosed herein provide potential benefits including the following. Electrical spacing is the pin-to-pin dimension. The PTH pad does not reduce the dielectric spacing, since the coverlays provide pad-to-pad insulation. A traditional conformal coating applied after connector installation cannot be verified as completely covering the PTH pad and requires significant masking to prevent inadvertent coating on the electrically conducting surfaces. Traditional conformal coatings applied prior to connector installation require the connector contact to pierce the coating and make reliable electrical connection to the PTH. The insulation in accordance with systems and methods as disclosed herein can be applied during the PCB manufacture, resulting in a precision application with no labor required in the production facility.

The methods and systems of the present disclosure, as described above and shown in the drawings, provide for insulation on PCB systems with tight spacing between contact pins and plated through hole (PTH) pads. While the apparatus and methods of the subject disclosure have been shown and described with reference to preferred embodiments, those skilled in the art will readily appreciate that changes and/or modifications may be made thereto without departing from the scope of the subject disclosure.

## Claims

1. A circuit board system comprising:
a printed circuit board, PCB (102), having a first side (104) and a second side (106) opposite the first side (104), wherein a plurality of plated through holes, PTHs (108), are defined through the PCB (102) from the first side (104) to the second side (106);
a respective pad (110) is defined at each end of each PTH of the plurality of PTHs (108), wherein the PCB (102) includes circuit traces electrically interconnecting among the plurality of PTHs (108) for forming PCB circuitry; and
a coverlay (114) adhered to the first side (104) of the PCB (102) for insulating voltages among the plurality of PTHs (108).

2. The system as recited in claim 1, further comprising a plurality of pin contacts, each pin contact of the plurality of pin contacts extending through the coverlay (114) and a respective one of the PTHs (108) of the plurality of PTHs (108).

3. The system as recited in claim 2, wherein the coverlay (114) includes an overhang in each of the plurality of PTHs (108) wherein the coverlay (114) extends radially inward toward the respective pin contact beyond the respective pad (110).

4. The system as recited in claim 3, wherein the coverlay (114) is a first coverlay (114) and further comprising a second coverlay (116) adhered to the second side (106) of the PCB (102).

5. The system as recited in claim 4, wherein the second coverlay (116) includes an overhang in each of the plurality of PTHs (108) wherein the coverlay extends radially inward toward the respective pin contact beyond the respective pad (110).

6. The system as recited in claim 5, wherein the plurality of pin contacts are compliant, seated within the respective lining of each PTH of the plurality of PTHs (108) with an interference fit; or wherein the plurality of pin contacts are secured within the respective pad (110) lining each PTH of the plurality of PTHs (108) with a solder joint, and optionally wherein an opening through the second coverlay for each pad is bigger than a corresponding opening through the first coverlay.

7. The system as recited in any preceding claim, wherein the coverlay (114) is a first coverlay (114) and further comprising a second coverlay (116) adhered to the second side (106) of the PCB (102).

8. The system as recited in any preceding claim, wherein the pads lining each PTH of the plurality of PTHs (108) are spaced apart from one another by as few as 17 thousandths of an inch (0.432 mm).

9. A method of making a circuit board system comprising:
adhering a coverlay (114) onto a first side (104) of a printed circuit board, PCB (102), having a second side (106) opposite the first side (104), wherein a plurality of plated through holes, PTHs (108), are defined through the PCB (102) from the first side (104) to the second side (106), wherein a respective pad (110) defined at each end of each PTH of the plurality of PTHs (108), and wherein the PCB (102) includes circuit traces interconnecting among the plurality of PTHs (108); and
placing a plurality of pin contacts through the coverlay (114), each pin contact of the plurality of pin contacts extending through the coverlay (114) and a respective one of the PTHs (108) of the plurality of PTHs (108) with the coverlay (114) insulating voltages among the plurality of PTHs (108).

10. The method as recited in claim 9, wherein the coverlay (114) includes an overhang in each of the plurality of PTHs (108) wherein the coverlay (114) extends radially inward toward the respective pin contact beyond the respective pad (110).

11. The method as recited in claim 10, wherein the coverlay (114) is a first coverlay (114) and further comprising adhering a second coverlay (116) onto the second side (106) of the PCB (102).

12. The method as recited in claim 11, wherein the second coverlay (116) includes an overhang in each of the plurality of PTHs (108) wherein the coverlay extends radially inward toward the respective pin contact beyond the respective pad (110).

13. The method as recited in claim 9, further comprising placing a plurality of pin contacts in the plurality if PTHs (108), respectively, after adhering the coverlay (114) onto the first side (104) of the PCB (102).

14. The method as recited in claim 13, wherein the plurality of pin contacts are compliant, and fit within the respective lining of each PTH of the plurality of PTHs (108) with an interference fit; or wherein placing the plurality of pin contacts includes piercing the coverlay (114) with the plurality of pin contacts after adhering the coverlay (114) onto the first side (104) of the PCB (102); or further comprising forming a plurality of holes for the plurality of pin contacts through the coverlay (114) prior to adhering the coverlay (114) to the first side (104) of the PCB (102) so the plurality of pin contacts can be placed through the coverlay (114) without piercing the coverlay (114).

15. The method as recited in claim 9, further comprising soldering the plurality of pin contacts to the respective pads, and optionally wherein the coverlay (114) is a first coverlay (114) and further comprising:
adhering a second coverlay (116) onto the second side (106) of the PCB (102);
forming a first plurality of holes for the plurality of pin contacts through the first coverlay prior to adhering the first coverlay to the first side (104) of the PCB (102) so the plurality of pin contacts can be placed through the first coverlay (114) without piercing the first coverlay (114), wherein each hole in the first plurality of holes has a first diameter; and
forming a second plurality of holes for the plurality of pin contacts through the second coverlay prior to adhering the second coverlay to the second side (106) of the PCB (102) so the plurality of pin contacts can be placed through the second coverlay (116) without piercing the second coverlay (116), wherein each hole in the second plurality of holes has a second diameter larger than the first diameter so solder can be applied through the plurality of second holes to connect the plurality of pin contacts to the plurality of pads without thermally compromising the second coverlay (116).
